(19) Europäisches Patentamt
European Patent Office
Office européen des brevets

(11) **EP 4 746 216 A2**

(12) **EUROPEAN PATENT APPLICATION**

(43) Date of publication:
**20.05.2026 Bulletin 2026/21**

(21) Application number: **25210633.1**

(22) Date of filing: **23.10.2025**

(51) International Patent Classification (IPC):
**H01S 5/10** (2021.01)    **H01S 5/16** (2006.01)
**H01S 5/22** (2006.01)    **H01S 5/12** (2021.01)
**H01S 5/028** (2006.01)    **H01S 5/026** (2006.01)

(52) Cooperative Patent Classification (CPC):
**H01S 5/1085; H01S 5/0267; H01S 5/0287;
H01S 5/1014; H01S 5/1082; H01S 5/1203;
H01S 5/164; H01S 5/168; H01S 5/22;** H01S 5/101;
H01S 5/1039; H01S 2301/166; H01S 2301/176

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.10.2024 JP 2024188182
21.10.2025 JP 2025177239**

(71) Applicant: **Nichia Corporation
Anan-shi, Tokushima 774-8601 (JP)**

(72) Inventor: **MASUI, Shingo
Anan-shi, Tokushima, 774-8601 (JP)**

(74) Representative: **Betten & Resch
Patent- und Rechtsanwälte PartGmbB
Maximiliansplatz 14
80333 München (DE)**

(54) **SEMICONDUCTOR LASER ELEMENT**

(57)    A semiconductor laser element includes first and second regions in each of which a plurality of semiconductor layers are stacked, wherein the first region forms a resonator between a first end surface and a mirror region including a grating, in a top view, the first region includes an optical waveguide including: a core region extending in an optical axis direction of the resonator; and cladding regions arranged at both sides of the core region in a direction perpendicular to the optical axis direction, the second region is adjacent to the first region in the optical axis direction, in a top view, a width of the second region in the direction perpendicular to the optical axis direction is larger than a width of the core region in the direction perpendicular to the optical axis direction, and the second region includes a second end surface that emits a laser beam.

Fig. 1

EP 4 746 216 A2

# Description

## CROSS REFERENCE TO RELATED APPLICATION

This application claims priority to Japanese Patent Application No. 2024-188182, filed on October 25, 2024, and Japanese Patent Application No. 2025-177239, filed on October 21, 2025, the entire contents of which are hereby incorporated by reference.

## BACKGROUND

### TECHNICAL FIELD

The present disclosure relates to a semiconductor laser element.

### BACKGROUND ART:

When a high-output semiconductor laser element is realized, the end surface that emits a laser beam has a high light density of the laser beam, which may cause catastrophic optical damage (COD). Various methods have been employed to enhance COD resistance.

For example, as a semiconductor laser element, disclosed is: a semiconductor laser element, including: an optical active region including an optical waveguide and an optically passive region(s) provided at one or more ends of the optical waveguide; wherein at least one of the optically passive region(s) is broader than the optical waveguide so that, in use, an optical output of the optical waveguide diffracts upon traversing the at least one optically passive region (for example, see Japanese Patent Publication No. 2004-520710).

## SUMMARY

In the semiconductor laser element of Japanese Patent Publication No. 2004-520710, a low percentage of light returns from the end surface to the optical active region. Therefore, the semiconductor laser element of Japanese Patent Publication No. 2004-520710 may be difficult to efficiently resonate, which may make it difficult to emit high-output laser beam.

One object of an embodiment of the present disclosure is to provide a semiconductor laser element having high COD resistance while increasing output.

According to one embodiment, a semiconductor laser element includes a first region and a second region in each of which a plurality of semiconductor layers are stacked. The first region forms a resonator between a first end surface and a mirror region including a grating. In a top view, the first region includes an optical waveguide including a core region extending in an optical axis direction of the resonator; and cladding regions arranged at both sides of the core region in a direction perpendicular to the optical axis direction. The second region is adjacent to the first region in the optical axis direction. In a top view, a width of the second region in the direction perpendicular to the optical axis direction is larger than a width of the core region in the direction perpendicular to the optical axis direction. The second region includes a second end surface that emits a laser beam.

According to one embodiment, a semiconductor laser element includes a stack of a plurality of semiconductor layers, the semiconductor laser element including: a channel waveguide as a first region; a slab waveguide as a second region adjacent to the channel waveguide in an optical axis direction; and a grating. The channel waveguide includes a resonator formed between a first end surface and the grating. The slab waveguide includes a second end surface on a side opposite to the first end surface with respect to the grating, the second end surface configured to emit a laser beam.

According to one embodiment, a semiconductor laser element includes a stacked body in which a plurality of semiconductor layers are stacked. The stacked body includes: a first end surface, a second end surface that faces the first end surface and emits a laser beam, a first region arranged on a side of the first end surface, and a second region arranged on a side of the second end surface. The first region includes: an optical waveguide including: a core region extending along a first direction from the first end surface toward the second end surface; and a plurality of cladding regions arranged on both sides of the core region in a second direction perpendicular to both the first direction and a stacking direction of the stacked body, and a grating provided at least in a part of the first region. A width of the second region is larger than a width of the core region.

According to certain embodiments of the present disclosure, it is possible to provide a semiconductor laser element having high COD resistance while increasing output.

## BRIEF DESCRIPTION OF DRAWINGS

Fig. 1 is a schematic top view illustrating a semiconductor laser element according to a first embodiment;
Fig. 2 is a schematic cross-sectional view illustrating a cross section along the line II-II in Fig. 1;
Fig. 3 is a schematic cross-sectional view illustrating a cross section along the line III-III in Fig. 1;
Fig. 4 is a schematic cross-sectional view illustrating a cross section along the line IV-IV in Fig. 1;
Fig. 5 is a schematic top view illustrating a first modification of the semiconductor laser element according to the first embodiment;
Fig. 6 is a schematic top view illustrating a second modification of the semiconductor laser element according to the first embodiment;

Fig. 7 is a schematic top view illustrating a third modification of the semiconductor laser element according to the first embodiment;

Fig. 8 is a schematic cross-sectional view illustrating a cross section of a semiconductor laser element according to a second embodiment;

Fig. 9 is a schematic top view illustrating a semiconductor laser element according to a third embodiment;

Fig. 10 is a schematic cross-sectional view illustrating a cross section along the line X-X in Fig. 9;

Fig. 11 is a schematic cross-sectional view illustrating a semiconductor laser element according to a fourth embodiment;

Fig. 12 is a schematic top view illustrating a semiconductor laser element according to a fifth embodiment; and

Fig. 13 is a schematic top view illustrating the semiconductor laser element according to a sixth embodiment.

DETAILED DESCRIPTION

A semiconductor laser element according to one embodiment comprises a stacked body in which a plurality of semiconductor layers are stacked, wherein the stacked body comprises: a first end surface, a second end surface that faces the first end surface and emits a laser beam, a first region located on a side of the first end surface, and a second region located on a side of the second end surface; the first region comprises: an optical waveguide comprising: a core region extending along a first direction from the first end surface toward the second end surface; and a plurality of cladding regions located on both sides of the core region in a second direction perpendicular to both the first direction and a stacking direction of the stacked body, and a grating provided at least in a part of the first region; and a width of the second region is larger than a width of the core region.

Hereinafter, certain embodiments of the present invention will be described in detail. The following embodiments exemplify semiconductor laser elements and manufacturing methods thereof that embody the technical ideas of the present invention, but the present invention is not limited to the described embodiments.

First Embodiment

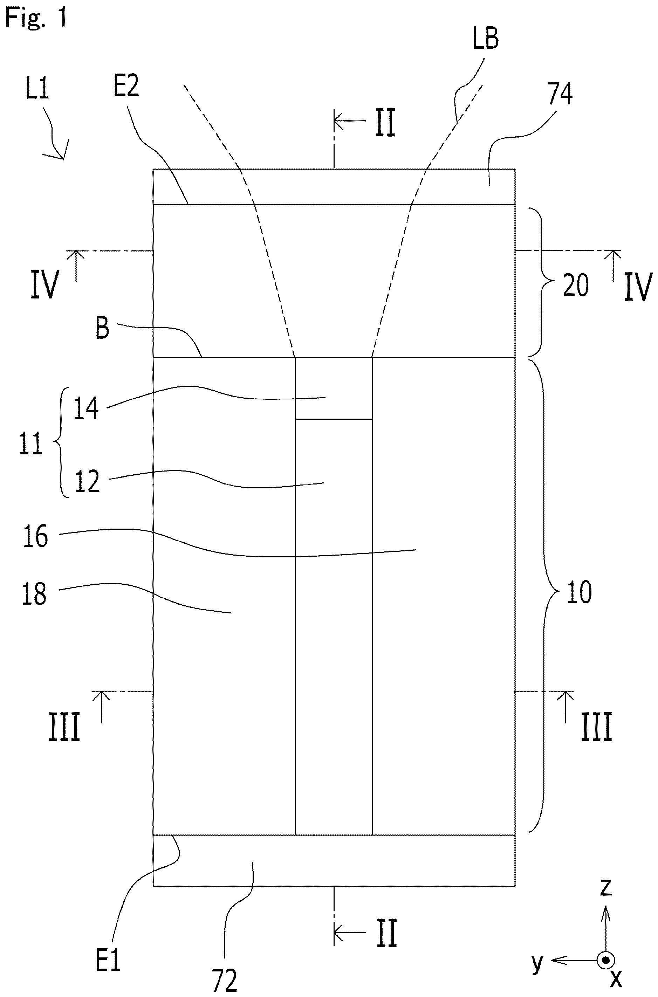

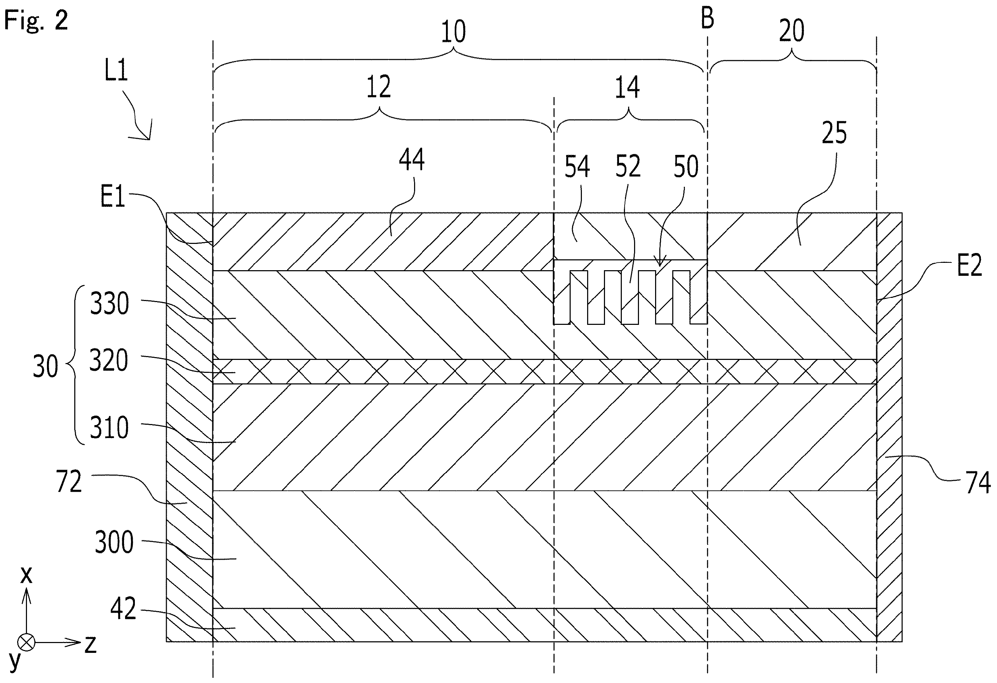

First, a summary of a semiconductor laser element L1 according to the first embodiment will be described with reference to Figs. 1 and 2. Fig. 1 is a schematic top view illustrating the semiconductor laser element L1 according to the first embodiment. Fig. 2 is a schematic cross-sectional view illustrating a cross section along the line II-II in Fig. 1.

<Semiconductor Laser Element L1>

The semiconductor laser element L1 of the first embodiment includes a distributed Bragg reflector (DBR) and has the following configuration. The semiconductor laser element L1 includes a first region 10 and a second region 20 in each of which a plurality of semiconductor layers are stacked, wherein the first region 10 forms a resonator 12 between a first end surface E1 and a mirror region 14 including a grating 50, in a top view, the first region 10 includes an optical waveguide including a core region 11 extending in an optical axis direction of the resonator 12; and cladding regions 16 and 18 arranged at both sides of the core region 11, in which the second region 20 is adjacent to the first region 10 in the optical axis direction, in a top view, the width of the second region 20 in a direction perpendicular to the optical axis direction is larger than the width of the core region 11 in the direction perpendicular to the optical axis direction, and the second region 20 has a second end surface E2 that emits a laser beam LB.

With this structure, it is possible to provide a semiconductor laser element having high COD resistance while increasing output.

In the specification, the stacking direction of the plurality of semiconductor layers may be referred to as the x direction; the optical axis direction of the resonator (that is the same as the optical axis direction of the optical waveguide and the extending direction of the core region) may be referred to as the z direction or the first direction; and the direction perpendicular to both the x direction and the z direction is referred to as the lateral direction, the y direction, or the second direction. The size measured along the z direction is referred to as "length," and the size measured along the y direction is referred to as "width."

The semiconductor laser element L1 includes a stacked body in which a plurality of semiconductor layers a stacked in the x direction. The semiconductor laser element L1 includes a first conduction-side semiconductor layer 310, a second conduction-side semiconductor layer 330, and an active layer 320 arranged between the first conduction-side semiconductor layer 310 and the second conduction-side semiconductor layer 330. The semiconductor laser element L1 has a first region 10 and a second region 20, and further has a first end surface E1 on the first region 10 side and a second end surface E2 on the second region 20 side. The first end surface E1 is a surface that reflects light generated in the stacked body, and the second end surface E2 is an end surface that emits a laser beam LB. The first end surface E1 and the second end surface E2 are arranged to face each other.

First Region 10

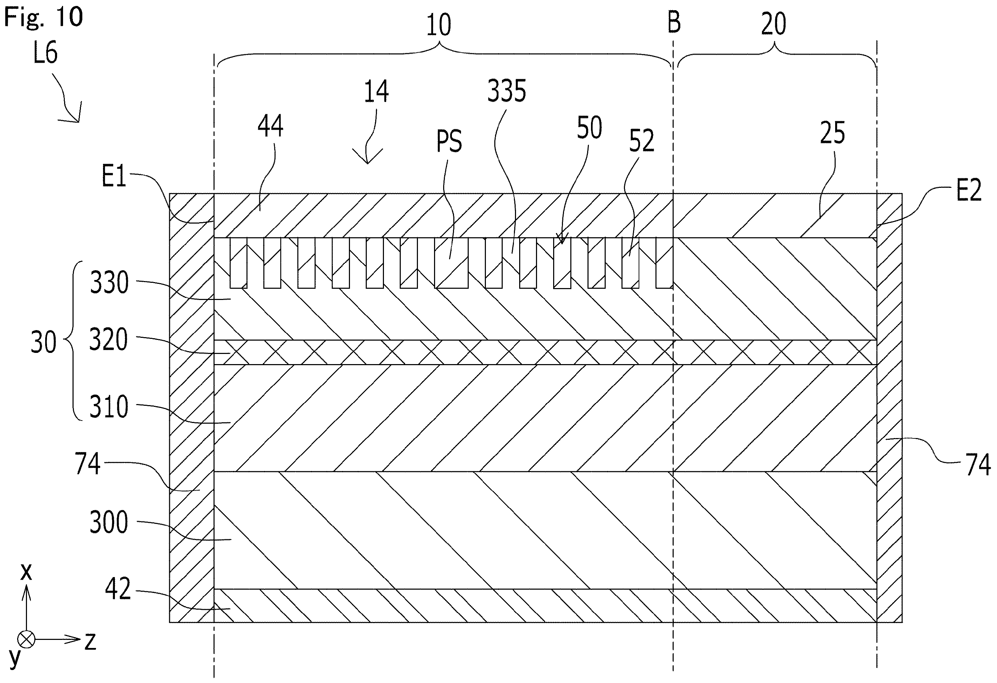

The first region 10 has a first end surface E1 and a mirror region 14. The mirror region 14 is a region including a grating 50. In a top view, the range of the mirror region 14 coincides with the range in which the grating 50 is formed. In a cross-sectional view, the mirror region 14 includes a region where the grating 50 is formed and a region immediately below the same. In Fig. 2, the region arranged between the two broken lines indicating both ends of the grating 50 in the z direction is the mirror region 14. With the grating 50 designed to reflect light having a predetermined wavelength, a resonator 12 is formed between the first end surface E1 and the mirror region 14. The effective reflection end of the grating 50 can be regarded as being positioned in the grating 50 (that is, in the mirror region 14). However, in the specification, as illustrated in Fig. 2, the resonator 12 is illustrated such that the end on the first end E1 side of both ends of the grating 50 represents the reflection end of the grating 50 for the sake of simplicity. The same applies to the following drawings (except for Fig. 10). In a top view, the first region 10 includes a core region 11 extending in the optical axis direction (z direction) of the resonator 12, and two cladding regions 16 and 18 positioned on both sides of the core region 11 in the lateral direction (y direction) and arranged such that the core region 11 is disposed between the two cladding regions 16 and 18. The core region 11 and the cladding regions 16 and 18 constitute an optical waveguide. When the optical waveguide is a refractive index waveguide, the core region 11 is a region having a relatively higher equivalent refractive index than the cladding regions 16 and 18; and, for a semiconductor laser element having a ridge formed therein, the core region 11 is a region immediately below the ridge region. When the optical waveguide is a gain waveguide, the core region 11 is a region immediately below a first electrode 44 formed in a stripe shape in the semiconductor laser element.

In the first region 10, light is confined in the stacking direction (x direction) by the plurality of semiconductor layers and is confined in the lateral direction (y direction) by the cladding regions 16 and 18. Therefore, the first region 10 can be regarded as a channel waveguide. Light is guided in the optical axis direction of the resonator 12 (z direction).

Second Region 20

The second region 20 is adjacent to the first region 10 in the optical axis direction of the resonator 12. In Fig. 1, the second region 20 is in contact with the first region 10. In a top view, the width of the second region 20 in the lateral direction (y direction) is larger than the width of the core region 11 of the first region 10 in the lateral direction (y direction). The second region 20 has a second end surface E2 that emits the laser beam LB.

In the second region 20, light is confined in the stacking direction (z direction) by the plurality of semiconductor layers. The second region 20 does not have a configuration corresponding to the core region 11 and the cladding regions 16 and 18 of the first region 10, or has a core region having a sufficiently broad width in the lateral direction (y direction). The width of the second region 20 is larger than the width of the laser beam LB. Therefore, in the second region 20, the laser beam LB is not confined in the lateral direction (y direction). Alternatively, the light confinement of the second region 20 in the lateral direction is weaker than the light confinement of the first region 10 in the lateral direction. Therefore, the laser beam LB entering the second region 20 from the first region 10 is guided while diverging in the lateral direction (y direction). That is, in the second region 20, the width of the laser beam diverges in the lateral direction (y direction). In the specification, the width of the laser beam LB is defined as D4$\sigma$. D4$\sigma$ is a width four times the standard deviation $\sigma$ of the intensity distribution in the stacking direction (z direction) or in the lateral direction (y direction). D4$\sigma$ is defined in the international standard of ISO.

The second region 20 is preferably a slab waveguide. When the second region 20 is a slab waveguide, light is not substantially confined in the lateral direction and easily diverges in the lateral direction. The light density of the laser beam LB further decreases at the second end surface E2, and the COD resistance can be enhanced. Light is guided in the optical axis direction of the resonator 12.

Next, the operation of the semiconductor laser element L1 according to the first embodiment will be described with reference to Fig. 1. In Fig. 1, the broken line represents how the laser beam LB diverges. The semiconductor laser element L1 has a semiconductor stacked body 30 in which semiconductor layers are stacked, and has a first region 10 and a second region 20. In the first region 10, light can be confined in the stacking direction (x direction) and the lateral direction (y direction) by the optical waveguide. In the first region 10, light confined by the optical waveguide is resonated by the resonator 12 formed by the first end surface E1 and the mirror region 14 (more specifically, the grating 50 included in the mirror region 14), and the light can be efficiently amplified. The second region 20 guides the laser beam LB amplified in the first region 10. With the width of the second region 20 in the lateral direction larger than the width of the core region 11 in the first region 10, the width of the laser beam LB can be increased in the second region 20. With this structure, the light density of the laser beam LB decreases at the second end surface E2 so that the COD resistance can be enhanced. Therefore, the semiconductor laser element L1 according to the first embodiment can enhance the COD resistance while increasing the light output.

In a top view, the width of the second end surface E2 in the direction perpendicular to the optical axis direction (z direction) (in the y direction, that is, in the lateral direction) is larger than the width of the laser beam LB at the second end surface E2, and in a top view, the width of the second region 20 in the direction perpendicular to the optical axis direction (z direction) (in the y direction, that is, in the lateral direction) is preferably constant in the optical axis direction. Consequently, the width of the second region 20 is always larger than the width of the laser beam LB guided in the second region 20. Therefore, the laser beam LB can freely diverge in the lateral direction (y direction), and thus the light density of the laser beam LB can be reduced at the second end surface E2 to enhance COD resistance.

The length of the first region 10 in the optical axis direction (z direction) may be, for example, 1000 $\mu$m or more and 10000 $\mu$m or less, and preferably 2000 $\mu$m or more and 6000 $\mu$m or less. When the length of the grating 50 is constant and the first region 10 becomes relatively long, the resonator becomes relatively long so that light can be efficiently amplified.

The length of the second region 20 in the optical axis direction (z direction) may be, for example, 0.01 or more and 0.35 or less times, and preferably 0.01 or more and 0.1 or less times the length of the first region in the optical axis direction (z direction). As a result, the length of the second region 20, which does not contribute to oscillation, is shorter than that of the first region 10, and the light emission efficiency is less likely to decrease. The width of the second region 20 in the lateral direction (y direction) may be 1.5 or more and 100 or less times, preferably 2 or more and 100 or less times, the width of the core region in the first region 10. As a result, the laser beam LB sufficiently diverges in the lateral direction in the second region 20, and the light density of the laser beam LB decreases at the second end surface E2. Therefore, COD resistance can be enhanced.

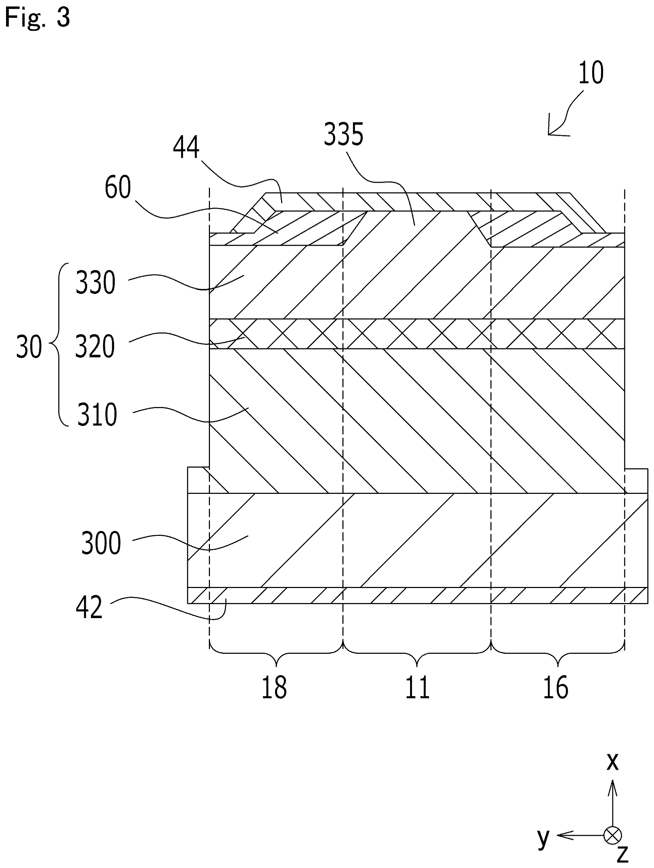

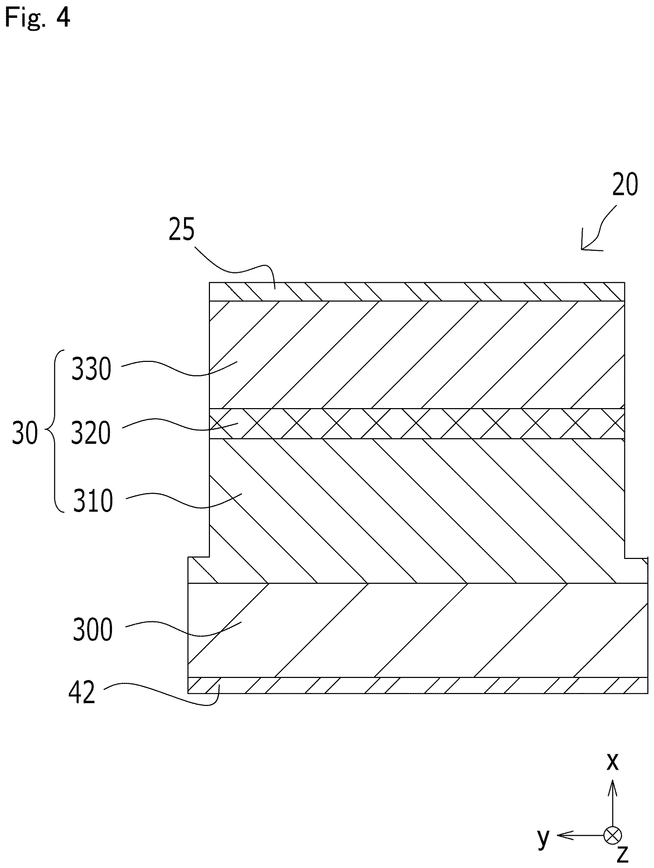

A summary of the semiconductor laser element L1 according to the first embodiment has been described so far. Hereinafter, each member constituting the semiconductor laser element L1 will be described with reference to Figs. 2, 3, and 4. Fig. 2 is a schematic cross-sectional view illustrating a cross section along the line II-II in Fig. 1. Fig. 3 is a schematic cross-sectional view illustrating a cross section along the line III-III in Fig. 1. Fig. 4 is a schematic cross-sectional view illustrating a cross section along the line IV-IV in Fig. 1.

Substrate 300

The substrate 300 supports the semiconductor stacked body 30. The substrate 300 may be a growth substrate for the semiconductor stacked body 30. The substrate 300 may be a GaN substrate, a GaAs substrate, an InP substrate, or the like. The substrate 300 may contain a first conduction-type impurity. The first conduction-type may be n-type. The impurity may be, for example, silicon or germanium.

Semiconductor Stacked Body 30

The semiconductor stacked body 30 is arranged on the substrate 300. The semiconductor stacked body 30 includes a first conduction-side semiconductor layer 310, a second conduction-side semiconductor layer 330, and an active layer 320 arranged between the first conduction-side semiconductor layer 310 and the second conduction-side semiconductor layer 330. The first conduction-side semiconductor layer 310, the second conduction-side semiconductor layer 330, and the active layer 320 contain a nitride semiconductor, an arsenide semiconductor, or a phosphide semiconductor. The first conduction-side semiconductor layer 310, the second conduction-side semiconductor layer 330, and the active layer 320 are preferably made of a nitride semiconductor. Because a nitride semiconductor has higher COD resistance than an arsenide semiconductor or a phosphide semiconductor, the COD resistance of the semiconductor laser element L1 can be further improved. As a result, it is possible to further increase the output of the semiconductor laser element L1. The semiconductor stacked body 30 is formed by, for example, the organometallic vapor phase growing method.

First Conduction-Side Semiconductor Layer 310

The first conduction-side semiconductor layer 310 is arranged on the substrate 300. The first conduction-side semiconductor layer 310 includes one or more semiconductor layers containing a first conduction-type impurity. When the first conduction-side semiconductor layer 310 is an n-side semiconductor layer, the first conduction-side semiconductor layer 310 may include an n-side cladding layer and an n-side light guide layer in this order from the substrate 300 side. A crack prevention layer may be provided between the substrate 300 and the n-side cladding layer.

Active Layer 320

The active layer 320 is arranged between the first conduction-side semiconductor layer 310 and the second conduction-side semiconductor layer 330. The active layer 320 may be a quantum well having a well layer and a barrier layer. The active layer 320 may be either a single quantum well (one well layer and two barrier layers) or a multiple quantum well (three or more barrier layers and two or more well layers each arranged between adjacent ones of the barrier layers). The wavelength of light emitted from the active layer 320 may be, for example, 360 nm or more and 2000 nm or less, preferably 360 nm or more and 780 nm or less, and more preferably 360 nm or more and 570 nm or less.

Second Conduction-Side Semiconductor Layer 330

The second conduction-side semiconductor layer 330 is arranged on the active layer 320. The second conduction-side semiconductor layer 330 includes one or more semiconductor layers containing a second conduction-type impurity. When the second conduction-side semiconductor layer 330 is a p-side semiconductor layer, the second conduction-side semiconductor layer 330 may include a p-side light guide layer, an electron blocking layer, and a p-side contact layer in this order from the active layer 320 side. The p-side light guide layer may be an undoped semiconductor layer. The electron blocking layer and the p-side contact layer may be a p-type semiconductor layer containing a p-type impurity. The second conduction-side semiconductor layer 330 may further include a p-side cladding layer. The p-side cladding layer is not limited to a semiconductor layer, and may be a light-transmissive electrode or a protective film.

Grating 50

The mirror region 14 having a grating 50 functions as a Bragg waveguide. The grating 50 reflects light having a wavelength that satisfies the Bragg condition. In the semiconductor laser element L1 of the first embodiment, the grating 50 as illustrated in Fig. 2 has a periodic structure in which a plurality of protrusions provided in the second conduction-side semiconductor layer 330 (for example, a p-side semiconductor layer) and a first medium 52 filling the recesses between adjacent ones of the protrusions are periodically arranged in the optical axis direction of the resonator (in the z direction). The protrusion of the second conduction-side semiconductor layer 330 is the portion that has not been etched when the plurality of recesses is formed by etching or the like. The method for forming the grating 50 includes, for example, periodically forming a plurality of recesses in the second conduction-side semiconductor layer 330 by dry etching, and forming a first medium 52 in each recess. The dry etching is, for example, reactive ion etching (RIE), by which recesses can be formed at a predetermined position of the second conduction-side semiconductor layer 330 through a mask patterned by electron beam lithography or nanoimprinting. The depth of the recess can be controlled by etching conditions (for example, etching time).

The lower end of the grating 50 coincides with the position of the bottom of the recesses. When the depth of the plurality of recesses is not constant, the lower end of the grating 50 is defined as the position of the deepest bottom of the recesses. The lower end of the grating 50 may be positioned in the middle of the thickness direction of the second conduction-side semiconductor layer 330. The lower end of the grating 50 may be positioned in the p-side light guide layer. As a result, the grating 50 becomes closer to the active layer 320, the coupling coefficient between light guided in the first region 10 and the grating 50 is improved, and light can be efficiently reflected.

When the oscillation wavelength (Bragg wavelength) is $\lambda_B$, the period of the grating 50 is A, the order of the grating is q, and the equivalent refractive index of the mirror region 14 in which the grating 50 is provided is $n_{eq}$, the relationship of the following formula (1) is satisfied.

$$\lambda_B \times q = 2 \times n_{eq} \times \Lambda \cdots (1)$$

The period A of the grating 50 may be, for example, 40 nm or more and 400 nm or less, 50 nm or more and 300 nm or less, or 60 nm or more and 250 nm or less.

The reflectance of the grating 50 at a predetermined wavelength may be 3% or more and 50% or less, and preferably 5% or more and 18% or less. The length of the grating 50 in the periodic direction may be 50 $\mu$m or more and 600 $\mu$m or less.

Because the resonator 12 is formed between the mirror region 14 including the grating 50 and the first end surface E1, the resonance conditions can be adjusted by appropriately setting the position of the grating 50. It is preferable that the grating 50 is provided only in the first region 10, and in a cross-sectional view in the zx plane including the optical axis direction (z direction) and the stacking direction (x direction), the center of the grating 50 is closer to the second end surface E2 than the first end surface E1. Thereby, the resonator becomes long and light can be efficiently amplified through resonance.

In a cross-sectional view in the zx plane, the center of the grating 50 coincides with the position of the middle point of the distance between both ends of the grating 50 (the entire length of the grating 50) in the z direction. Note that one end of the grating 50 is located at the position of the inner side surface on the first end surface E1 side in the recess closest to the first end surface E1, and the other end of the grating 50 is located at the position of the inner side surface on the second end surface E2 side in the recess closest to the second end surface E2.

Here, the distance from the center of the grating 50 to the first end surface E1 is the sum of the distance from the first end surface E1 to the grating 50 (that is, to one end of the grating 50) and 1/2 of the entire length of the grating 50. Similarly, the distance from the center of the grating 50 to the second end surface E2 is the sum of the distance from the second end surface E2 to the grating 50 (that is, to the other end of the grating 50) and 1/2 of the entire length of the grating 50. Therefore, "the center of the grating 50 is closer to the second end surface E2 than the first end surface E1" is synonymous with "the distance from the second end surface E2 to the grating 50 is shorter than the distance from the first end surface E1 to the grating 50."

In a top view, the grating 50 may be provided only in a region overlapping the core region 11, or may be provided from a region overlapping the core region 11 to a region overlapping the cladding regions 16 and 18.

First Medium 52

The first medium 52 is a material that fills the plurality of recesses formed in the second conduction-side semiconductor layer 330. The refractive index of the first medium 52 is different from the refractive index of the second conduction-side semiconductor layer 330.

Thereby, with a difference in refractive index between the first medium 52 and the second conduction-side semiconductor layer 330, the periodic structure thereof can function as the grating 50.

The first medium 52 may be, for example, an oxide, a fluoride, or a nitride. The material of the first medium 52 may be, for example, at least one selected from the group consisting of indium tin oxide, indium zinc oxide, aluminum oxide, silicon oxide, titanium oxide, magnesium fluoride, barium fluoride, lanthanum fluoride, silicon nitride, aluminum nitride, gallium nitride, aluminum gallium nitride, indium gallium nitride, and silicon oxynitride. When the plurality of recesses of the second conduction-side semiconductor layer 330 is filled with the first medium 52, the area exposed to air is decreased within the inner surface of the recesses of the second conduction-side semiconductor layer 330 so that deterioration of the second conduction-side semiconductor layer 330 is reduced.

The first medium 52 can be formed by a sputtering method, an atomic layer deposition method, a vapor deposition method, a chemical vapor deposition method, a sol-gel method, or the like. The upper surface of the first medium 52 is not necessarily flush with the upper surface of the second conduction-side semiconductor layer 330. As illustrated in Fig. 2, the upper surface of the first medium 52 may be higher than the upper surface of the second conduction-side semiconductor layer 330.

Ridge 335

As illustrated in Fig. 3, the second conduction-side semiconductor layer 330 has a ridge 335. The ridge 335 defines the core region 11. The width of the core region 11 substantially matches the width of the ridge. The width of the ridge is defined as the width of the lower end of the ridge. When the semiconductor laser element L1 has the ridge 335, it is possible to provide a difference in refractive index between the core region 11 and the cladding regions 16 and 18, allowing light to be easily confined in the lateral direction. Note that the optical waveguide formed in the first region 10 is not limited to a ridge waveguide, and may be another refractive index waveguide. The optical waveguide may be a gain waveguide. In the case of a gain waveguide, the width of the core region 11 substantially matches the stripe width of the first electrode 44.

Transverse Mode

In the lateral direction, the optical waveguide of the first region 10 may be a single-mode waveguide. In the semiconductor laser element in which the lateral direction mode is a single mode, light with good beam quality can be amplified, and the amplified light can be extracted from the second end surface E2 as a high-output laser beam LB. At this time, the width of the core region 11 in the first region 10 may be, for example, 0.5 $\mu$m or more and 5 $\mu$m or less, and preferably 1 $\mu$m or more and 3 $\mu$m or less. Note that the "light with good beam quality" means light in a state where the $M^2$ factor is close to 1. For example, the $M^2$ factor may be 1 or more and 1.2 or less.

In the lateral direction, the optical waveguide of the first region 10 may be a multi-mode waveguide. In the semiconductor laser element including a multi-mode optical waveguide as mode of the lateral direction, an even higher-output laser beam LB can be extracted from the second end surface E2 as compared with the semiconductor laser element including a single mode waveguide. In this case, the width of the core region 11 in the first region 10 may be, for example, 5 $\mu$m or more and 200 $\mu$m or less.

High Reflection Coat 72

A high reflection coat 72 is formed on the first end surface E1. The reflectance of the high reflection coat 72 may be, for example, 80% or more and 99.99% or less, and preferably 90% or more and 99.99% or less, with respect to the oscillation wavelength. As a result, light can be efficiently resonated and amplified. The high reflection coat 72 may be a dielectric multilayer film or a metal reflective film.

Antireflection Coat 74

An antireflection coat 74 may be formed on the second end surface E2. The reflectance of the antireflection coat 74 may be, for example, 0.01% or more and 5% or less, and preferably 0.01% or more and 1% or less, with respect to the oscillation wavelength. As a result, reflection on the second end surface E2 is reduced, and COD resistance is further improved. In addition, reflection on the second end surface E2 is reduced, and therefore returning light is also reduced, which contributes to stable laser oscillation. The antireflection coat 74 may be a dielectric multilayer film.

Next, the configuration of the electrode and the like will be described with reference to Figs. 2, 3, and 4.

First Electrode 44

The first electrode 44 is an electrode formed on the upper surface of the second conduction-side semiconductor layer 330 in the first region 10. The first electrode 44 is in contact with the second conduction-side semiconductor layer 330 in the first region 10. As illustrated in Figs. 2 and 3, the first electrode 44 is formed on the optical waveguide, and is connected to the second conduction-side semiconductor layer 330 in the core region 11. The first electrode 44 may be, for example, a light-transmissive oxide or a metal. The light-transmissive oxide is, for example, indium tin oxide or indium zinc oxide. The metal is, for example, nickel, gold, rhodium, chromium, tungsten, platinum, titanium, aluminum, and alloys thereof. The first electrode 44 may be a single layer or a multilayer (that is, a stacked body).

The first electrode 44 may be arranged on the second conduction-side semiconductor layer 330 in the second region 20. In this case, an insulating third medium 25 is arranged between the first electrode 44 and the second conduction-side semiconductor layer 330 in the second region 20. Therefore, the second conduction-side semiconductor layer 330 in the second region 20 is not in contact with the first electrode 44. As a result, unintended current injection into the second region 20 is reduced.

Second Electrode 42

The second electrode 42 is an electrode formed on the substrate 300 side. In the example illustrated in Fig. 2, the second electrode 42 is formed on the back surface of the substrate 300. The second electrode 42 may be, for example, a light-transmissive oxide or a metal. The light-transmissive oxide is, for example, indium tin oxide or indium zinc oxide. The metal is, for example, nickel, gold, rhodium, chromium, tungsten, platinum, titanium, aluminum, and alloys thereof. The second electrode 42 may be a single layer or a multilayer (that is, a stacked body).

As illustrated in Fig. 3, an insulating layer 60 is formed to protect the side surface of the ridge and the upper surface of the second conduction-side semiconductor layer 330 on both sides of the ridge. This makes it possible to reduce current injection into unnecessary portions such as the semiconductor stacked body 30 that is not immediately below the ridge. The insulating layer 60 may be, for example, aluminum oxide, silicon oxide, silicon nitride, or the like.

Second Medium 54

A second medium 54 is formed on the upper surface of the grating 50 in the mirror region 14, specifically, on the upper surface of the first medium 52 of the grating 50. The semiconductor stacked body 30 in the mirror region 14 is not necessarily energized, and the material of the second medium 54 being conductive is optional. The material of the second medium 54 may be a light-transmissive oxide, metal, air, or an insulator. The material of the second medium 54 may be, for example, indium tin oxide, aluminum oxide, silicon oxide, silicon nitride, gold, platinum, titanium, palladium, or chromium. The second medium 54 may be the same material as the first electrode 44.

Third Medium 25

The third medium 25 is arranged on the second conduction-side semiconductor layer 330 in the second region 20. The third medium 25 is preferably an insulator in order to prevent unintended energization to the second region 20. The material of the third medium 25 may be, for example, aluminum oxide, silicon oxide, silicon nitride, tantalum oxide, or niobium oxide.

For the case where the third medium 25 is not an insulator, the operation of the semiconductor laser element L1 according to the first embodiment when current is injected into the semiconductor laser element L1 will be described. On the semiconductor stacked body 30 of the semiconductor laser element L1, the first electrode 44 is formed from the first region 10 to the second region 20. The first electrode 44 is arranged only on the ridge 335 (that is, on the core 12) in the first region 10, and is arranged on the entire upper surface of the semiconductor stacked body 30 in the second region 20. The semiconductor laser element L1 of the first embodiment can be driven by current injection from the first electrode 44. For example, a case where current is injected into the first region 10 and the second region 20 at an equal current density through the first electrode 44 is considered. In this case, resonance occurs in the first region 10 to generate the laser beam LB. In the second region 20, the laser beam LB is guided, and the laser beam LB is extracted from the second end surface E2. However, because the width of the second region 20 in the lateral direction is larger than the width of the core region 11 in the first region 10 in the lateral direction, it is more difficult to uniformly inject current into the entire second region 20 than the core region 11. Therefore, when current is injected into the second region 20, the second region 20 may have a temperature distribution or a carrier distribution in the lateral direction. Because the refractive index of each semiconductor layer depends on the temperature, the temperature distribution in the second region 20 may lead to a refractive index distribution in the second region 20. In addition, when current is injected at a large current density, the carrier distribution may also cause a refractive index distribution due to free carrier plasma effect or spatial hole burning. The refractive index distribution also leads to light confinement in the lateral direction in the second region 20, and therefore there may be a case in which laser beam guided in the second region 20 does not sufficiently diverge in the second region 20.

Therefore, in the semiconductor laser element L1 according to the first embodiment, the first electrode 44 is formed on the second conduction-side semiconductor layer 330 in the first region 10, while the third medium 25 is formed on the second conduction-side semiconductor layer 330 in the second region 20. When the third medium 25 is an insulator, current flowing from the first electrode 44 to the second region 20 can be reduced or inhibited. As a result, the second region 20 is less likely to have a temperature distribution or a carrier distribution to lead to light confinement in the lateral direction in the second region 20. Therefore, the laser beam LB can diverge to a desired size in the second region 20 and then be emitted from the second end surface E2. Therefore, COD resistance can be enhanced.

However, current may be injected into the second region 20 as long as the current density is about equal to or less than the transparency current density. When a current of such a current density is injected, the effect of reducing light absorption can be obtained in the second region 20, so that the output of the laser beam LB can be increased. In addition, when a current of such a current density is injected, the temperature distribution or carrier distribution as described above are hardly generated, and the beam quality of the laser beam LB guided in the second region 20 is less likely to deteriorate. When current is injected at a current density equal to or less than the transparency current density, a material having high thermal conductivity may be selected as the third medium 25. The third medium 25 may be, for example, gold, platinum, titanium, palladium, chromium, or the like.

In the first region 10, current injection into the mirror region 14 is optional, but the mirror region 14 is preferably electrically conductive. When electricity is supplied to the mirror region 14, light absorption in the active layer 320 in the mirror region 14 can be reduced, and the output of the laser beam LB can be increased.

When the first region 10 is a channel waveguide, and the second region 20 is a slab waveguide, the semiconductor laser element L1 according to the first embodiment can also be described with the following configuration. That is, the semiconductor laser element L1 is a semiconductor laser element L1 in which a plurality of semiconductor layers are stacked, the semiconductor laser element L1 including: a channel waveguide as a first region, and a slab waveguide as a second region adjacent to the channel waveguide in the optical axis direction of the channel waveguide, wherein the channel waveguide has a resonator 12 formed of a first end surface E1 and a grating 50, and the slab waveguide has a second end surface E2 capable of emitting a laser beam LB on a side opposite to the first end surface E1 via the grating 50.

In the semiconductor laser element L1, light is resonated and amplified in the channel waveguide including the grating 50, and the laser beam LB diverges in the slab waveguide and extracted from the second end surface E2. Thereby, it is possible to obtain a semiconductor laser element having high COD resistance while increasing output.

In a top view, the channel waveguide includes a core region extending in the optical axis direction of the resonator, and cladding regions arranged at both sides of the core regions in the direction perpendicular to the optical axis direction (y direction). The channel waveguide is preferably a ridge waveguide. As a result, light can be easily confined in the lateral direction (y direction). In the lateral direction (y direction), the channel waveguide may be a single-mode waveguide. In the semiconductor laser element in which the lateral direction mode is a single mode, light with good beam quality can be amplified, and the high-output laser beam LB can be extracted from the second end surface E2.

First Modification

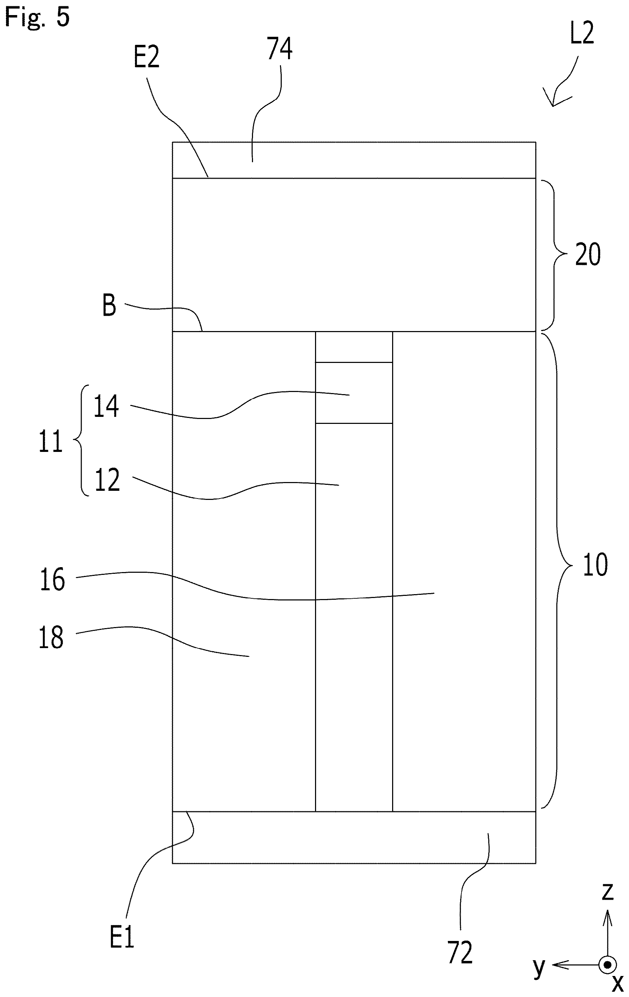

The semiconductor laser element L2 according to the first modification is a modification of the semiconductor laser element L1 according to the first embodiment. Fig. 5 is a schematic top view illustrating the semiconductor laser element L2 according to the first modification. The semiconductor laser element L2 according to the first modification is different from the semiconductor laser element L1 according to the first embodiment in that none of the ends of the mirror region 14 coincides with the boundary B between the first region 10 and the second region 20, and both the end on the first end E1 side and the end on the second end E2 side are positioned in the first region 10. In other points, the configuration of the first modification is similar to that of the semiconductor laser element L1 according to the first embodiment. The "both ends of the mirror region 14" is both ends of the mirror region 14 in a cross-sectional view in the x-z plane. That is, the "both ends of the mirror region 14" substantially coincides with "both ends of the grating 50" as described in the first embodiment.

Even with such a configuration, it is possible to obtain a semiconductor laser element having high COD resistance while increasing output.

When both ends of the mirror region 14 do not overlap the boundary B between the first region 10 and the second region 20, the degree of freedom is increased at the time of manufacturing the semiconductor laser element L2, and the semiconductor laser element L2 is easily manufactured.

Second Modification

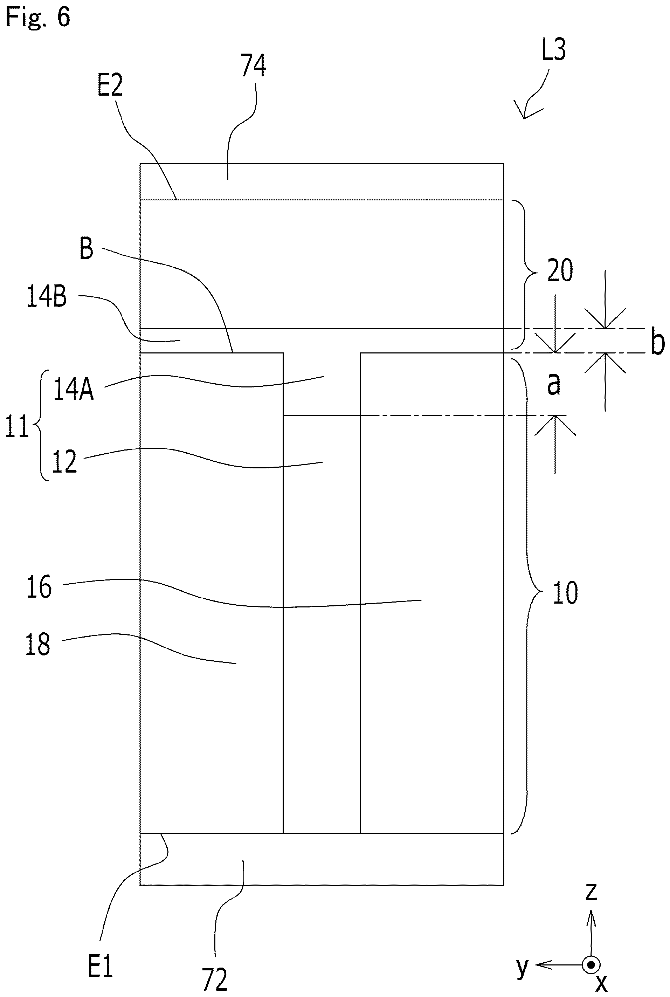

The semiconductor laser element L3 according to the second modification is a modification of the semiconductor laser element according to the first embodiment. Fig. 6 is a schematic top view illustrating the semiconductor laser element L3 according to the second modification. In the semiconductor laser element L3 according to the second modification, none of the ends of the mirror region 14 coincides with the boundary B between the first region 10 and the second region 20, and the end on the first end E1 side is positioned in the first region 10 and the end on the second end E2 side is positioned in the second region 20. In a cross-sectional view in the z-x cross section along the optical axis direction (z direction) and the stacking direction (x direction), the percentage of the length of the grating 50 in the z direction that is located in the first region 10 with respect to the entire length of the grating 50 is larger than 50%. In other points, the configuration of the second modification is similar to that of the semiconductor laser element L1 according to the first embodiment. As described later, using "a" and "b" illustrated in Fig. 6, "the entire length of the grating 50 in the x direction" is (a + b), and "the length of the grating 50 that is arranged in the first region 10" is "a."

Even with such a configuration, it is possible to obtain a semiconductor laser element having high COD resistance while increasing output.

The mirror region 14 has a first mirror region 14A formed in the first region 10, and a second mirror region 14B formed in the second region 20. The first mirror region 14A and the second mirror region 14B are continuous to each other. When light diverges in the second region 20 and reflected by the grating 50 positioned in the second region 20, the percentage of light fed back to the resonator 12 in the first region 10 is decreased. Note that the grating 50 can be regarded as a multilayer mirror incorporated in a semiconductor layer. Every time light passes through one film constituting the multilayer mirror, the power of the forward wave of the light decreases. In the semiconductor laser element L3 according to the second modification, in the cross-sectional view in the optical axis direction, more than 50% of the entirety of the grating 50 is located in the first region 10. Therefore, in the semiconductor laser element L3 according to the second modification, most of the light can be reflected by the grating 50 formed in the first region 10 to be fed back to the resonator 12. Therefore, the semiconductor laser element L3 according to the second modification can efficiently amplify light.

In Fig. 6, in a cross-sectional view in the z-x cross section along the optical axis direction (z direction) and the stacking direction (x direction), when the length from the end of the mirror region 14 positioned in the first region 10 (the end on the first end E1 side) to the boundary B between the first region 10 and the second region 20 (that is, the length of the first mirror region 14A) is defined as "a," and the length from the boundary B between the first region 10 and the second region 20 to the end of the mirror region 14 positioned in the second region 20 (the end on the second end E2 side) (that is, the length of the second mirror region 14B) is defined as "b," $a/(a + b) \times 100$ (%) may be 50% or more and less than 100%, preferably 75% or more and less than 100%, and more preferably 90% or more and less than 100%.

When neither of the ends of the mirror region 14 coincides with the boundary B between the first region 10 and the second region 20, the degree of freedom is increased at the time of manufacturing the semiconductor laser element L3, and the semiconductor laser element L3 is easily manufactured.

Third Modification

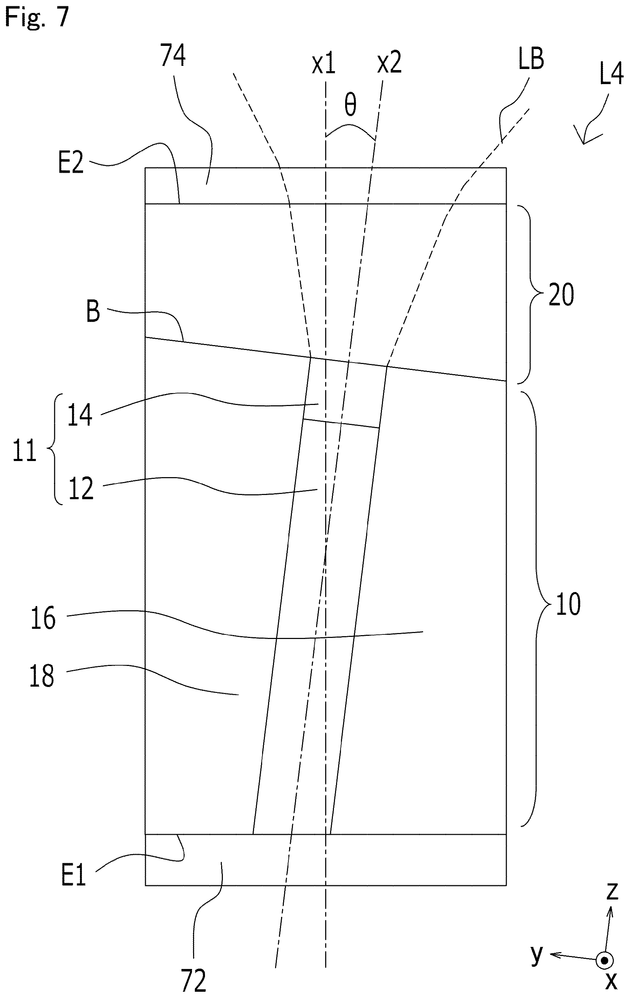

Fig. 7 is a schematic top view illustrating the semiconductor laser element L4 according to the third modification. The semiconductor laser element L4 according to the third modification is different from the semiconductor laser element L1 according to the first embodiment in that the optical axis X2 of the resonator 12 is inclined by an angle θ with respect to the normal line X1 normal to the second end surface E2. Other points thereof are similar to those of the semiconductor laser element L1 according to the first embodiment.

Even with such a configuration, it is possible to obtain a semiconductor laser element having high COD resistance while increasing output.

When the optical axis X2 is inclined with respect to the normal line X1, laser light that has been reflected by the second end surface E2 or by optical components used in combination with the semiconductor laser element L4 and thus returning to the resonator 12 is further reduced, so that returning-light resistance can be further enhanced. The angle θ may be, for example, 0.01 degree or more and 10 degree or less.

The periodic direction of the grating 50 formed in the mirror region 14 coincides with the direction of the optical axis X2 of the resonator 12 (z direction). Because the boundary B between the first region 10 and the second region 20 is formed such that the boundary B is perpendicular to the optical axis X2 of the resonator 12, the boundary B between the first region 10 and the second region 20 is also inclined by the angle θ with respect to the second end surface E2 in accordance with the inclination of the optical axis X2 of the resonator 12.

Second Embodiment

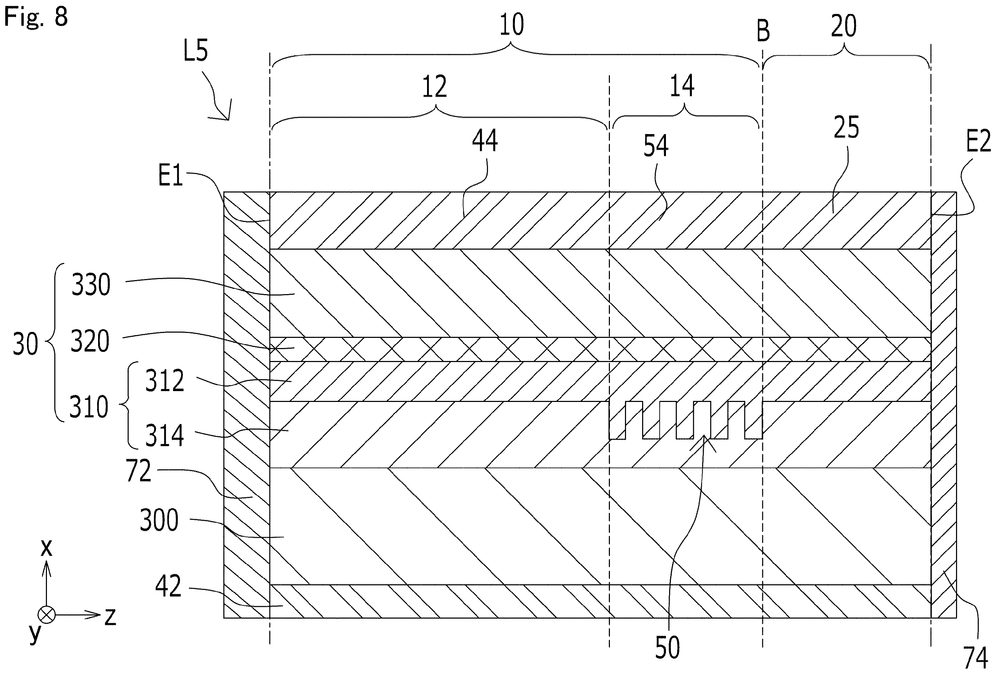

Fig. 8 is a schematic cross-sectional view illustrating a cross section of a semiconductor laser element L5 according to a second embodiment. The semiconductor laser element L5 according to the second embodiment is different from the semiconductor laser element L1 according to the first embodiment in that the grating 50 is formed in the first conduction-side semiconductor layer 310 in the first region 10. Other features of the second embodiment are similar to those of the semiconductor laser element L1 according to the first embodiment.

Even with such a configuration, it is possible to obtain a semiconductor laser element having high COD resistance while increasing output.

When the first conduction-side semiconductor layer 310 is an n-side semiconductor layer, the first conduction-side semiconductor layer 310 may include an n-side cladding layer 314 and an n-side light guide layer 312 in this order from the substrate 300 side. In the example illustrated in Fig. 8, the grating 50 is formed as follows: a plurality of protrusions provided on the upper surface side of the n-side cladding layer 314 and a plurality of protrusions provided on the lower surface side of the n-side light guide layer 312 are periodically arranged in the optical axis direction (x direction). However, the position where the grating 50 is formed and the like are not limited to the embodiment illustrated in Fig. 8. For example, optionally, the n-side cladding layer 314 has a multilayer structure of two or more layers, and the grating 50 is formed by the first n-side cladding layer and the second n-side cladding layer. Similarly, optionally, the n-side light guide layer 312 has a multilayer structure of two or more layers, and the grating 50 is formed by the first n-side light guide layer and the second n-side light guide layer. In addition, the grating 50 is not limited to a periodic structure of protrusions provided at the surface where two semiconductor layers are adjacent to each other. For example, in Fig. 8, the recesses (portions between the adjacent protrusions) of the n-side cladding layer 314 are filled with the protrusions of the n-side light guide layer 312, but the recesses may be filled with a medium having a refractive index different from the refractive index of the first conduction-side semiconductor layer 310.

Third Embodiment

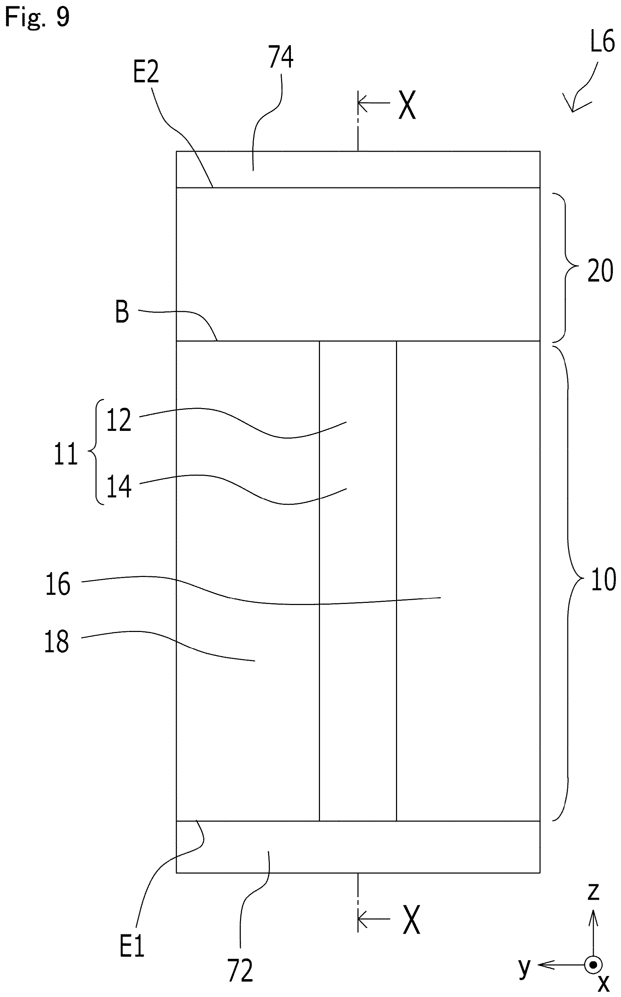

Fig. 9 is a schematic top view illustrating the semiconductor laser element L6 according to the third embodiment. Fig. 10 is a schematic cross-sectional view illustrating a cross section along the line X-X in Fig. 9. The semiconductor laser element L6 according to the third embodiment is a distributed feedback (DFB) laser element, and different from the semiconductor laser element L1 according to the first embodiment as follows. That is, as illustrated in Figs. 9 and 10, in the semiconductor laser element L6 according to the third embodiment, the first region 10 has a ridge 335, the grating 50 is provided only in the first region 10, and in a top view, the grating 50 is included in the entire region in which the ridge 335 is provided. Other features of the third embodiment are similar to those of the semiconductor laser element L1 according to the first embodiment.

Even with such a configuration, it is possible to obtain a semiconductor laser element having high COD resistance while increasing output.

The semiconductor laser element L6 operates as a distributed feedback laser element, and can perform laser oscillation in the single longitudinal mode or in a state close to the single longitudinal mode.

In Fig. 10, the grating 50 is provided only in the second conduction-side semiconductor layer 330 from the boundary B between the first region 10 and the second region 20 to the first end surface E1. The grating 50 may be provided in another position, for example, only in the first conduction-side semiconductor layer 310. In a top view as illustrated in Fig. 9, the grating 50 may be provided only in the core region 11, or may be provided from the core region 11 to the cladding regions 16 and 18.

The width of the ridge of the semiconductor laser element L6 is preferably determined such that the transverse mode in the lateral direction satisfies the single mode condition. As a result, the semiconductor laser element has a single transverse mode, and enables laser oscillation in the single longitudinal mode. The width of the ridge may be, for example, 0.5 $\mu$m or more and 5 $\mu$m or less.

The semiconductor laser element L6 may have a phase shift structure PS. The phase shift structure PS is preferably a 1/4 wavelength phase shift. This easily enables the single longitudinal mode to perform laser oscillation. When the phase shift structure PS is provided, an antireflection coat 74 is provided on the first end surface E1 and the second end surface E2. Note that the phase shift structure PS is not essential. When the phase shift structure PS is not provided, a high reflection coat 72 is provided on the second end surface E2.

Fourth Embodiment

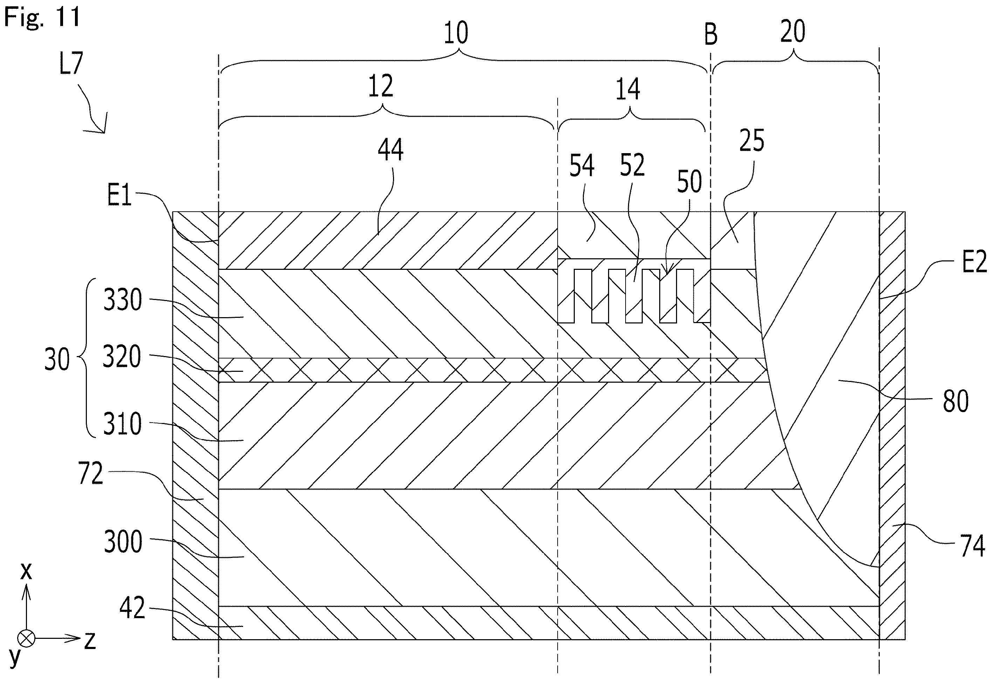

Fig. 11 is a schematic cross-sectional view illustrating a semiconductor laser element L7 according to a fourth embodiment. The semiconductor laser element L7 according to the fourth embodiment is different from the semiconductor laser element L1 according to the first embodiment as follows. That is, as illustrated in Fig. 11, the semiconductor laser element L7 according to the fourth embodiment is a semiconductor laser element L7 having a window structure 80 in the second region 20. The end of the mirror region 14 is not included in the window structure 80. That is, the window structure 80 is formed so as not to overlap the mirror region 14, and the end (end on the second end surface E2 side) of the mirror region 14 is not positioned in the window structure 80. Other features of the fourth embodiment are similar to those of the semiconductor laser element L1 according to the first embodiment.

Even with such a configuration, it is possible to obtain a semiconductor laser element having high COD resistance while increasing output.

The semiconductor laser element L7 according to the fourth embodiment performs laser oscillation in the red or infrared range. The semiconductor laser element L7 includes an arsenide semiconductor or a phosphide semiconductor formed on a GaAs substrate or an InP substrate. In the specification, red light means light having a peak wavelength in a range of 600 nm or more and less than 780 nm. Infrared light means light having a peak wavelength in a range of 780 nm or more and 2000 nm or less.

The window structure 80 is a region in which Zn or group III elements via vacancies are diffused, and has a larger band gap energy than the active layer 320 in the first region 10. Therefore, the boundary of the window structure 80 in a top view can be identified by performing microscopic photoluminescence measurement in the optical axis direction and checking the presence or absence of light absorption at each position.

Fifth Embodiment

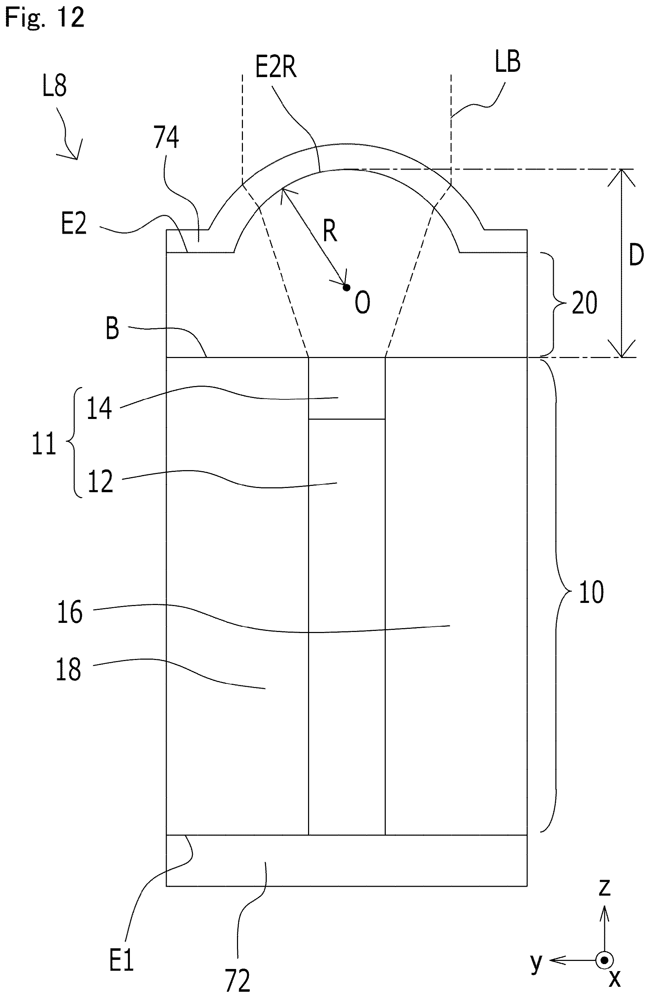

Fig. 12 is a schematic top view illustrating a semiconductor laser element L8 according to a fifth embodiment. The semiconductor laser element L8 according to the fifth embodiment is different from the semiconductor laser element L1 according to the first embodiment as follows. That is, as illustrated in Fig. 12, in the semiconductor laser element L8 according to the fifth embodiment, a part of the second end surface E2 has a convex lens surface E2R. That is, the semiconductor laser element L8 has a lens surface E2R at the second end surface E2. The laser beam LB can pass through the lens surface E2R. Other points of the fifth embodiment are similar to those of the semiconductor laser element L1 according to the first embodiment.

Even with such an embodiment, it is possible to obtain a semiconductor laser element having high COD resistance while increasing output.

The lens surface E2R is a convex lens surface. As a result, the component of the laser beam LB in the lateral direction (that is, slow axis direction) can be parallel light. In the specification, the parallel light includes a shift (divergence) of $\pm 4°$, preferably $\pm 2°$, from the perfect parallel light. The lens surface E2R can be formed by RIE on the surface on the second end surface E2 side of the semiconductor stacked body 30.

The lens surface E2R may be set such that the focal plane is positioned at the boundary B between the first region 10 and the second region 20. As a result, the component of the laser beam in the lateral direction can be efficiently converted into parallel light.

Because the resonator of the semiconductor laser element L8 is provided in the first region 10, the length of the resonator is constant regardless of the size and shape of the second region, as long as the length of the first region 10 and the position where the grating 50 is formed are constant. Therefore, the threshold current does not increase, even though the lens surface E2R is formed at the second end surface E2 and the entire length of the semiconductor laser element L8 increases by the protruding amount of the lens surface E2R as compared with the case where the lens surface E2R is not formed. Therefore, the length D from the boundary B between the first region 10 and the second region 20 to the vertex of the lens surface E2R can be set to an arbitrary value. As a result, light diverges to have a width of desired size in the lateral direction (y direction) in the second region 20, then passes through the lens surface E2R, where the component of the laser beam in the lateral direction can be made parallel light.

The length D and the curvature radius R of the lens surface E2R are appropriately set in accordance with the light confinement in the lateral direction (y direction) by the ridge portion of the first region 10. The length D may be, for example, 40 $\mu$m or more and 150 $\mu$m or less. The curvature radius R of the lens surface E2R may be, for example, 25 $\mu$m or more and 70 $\mu$m or less. The center O of the curvature radius R may be positioned in the second region 20.

The lens surface E2R may be a spherical surface or an aspherical surface. In particular, when the first region 10 is a multi-mode waveguide, the lens surface E2R is preferably an aspherical surface. Because the width in the lateral direction (y direction) of the multi-mode waveguide is larger than the width in the lateral direction (y direction) of the single-mode waveguide, the light emitting surface at the interface B between the first region 10 and the second region 20 is enlarged. In such a case, when the lens surface E2R has an aspherical surface, the component of laser beam in the lateral direction can be efficiently made parallel light. The aspherical surface may include an elliptical surface or a parabolic surface.

As illustrated in Fig. 12, the antireflection coat 74 provided on the second end surface E2 is also arranged on the lens surface E2R. The antireflection coat 74 provided on the lens surface E2R is arranged along the curved surface of the lens surface E2R. As a result, reflection on the second end surface E2 is reduced, and COD resistance is further improved.

Sixth Embodiment

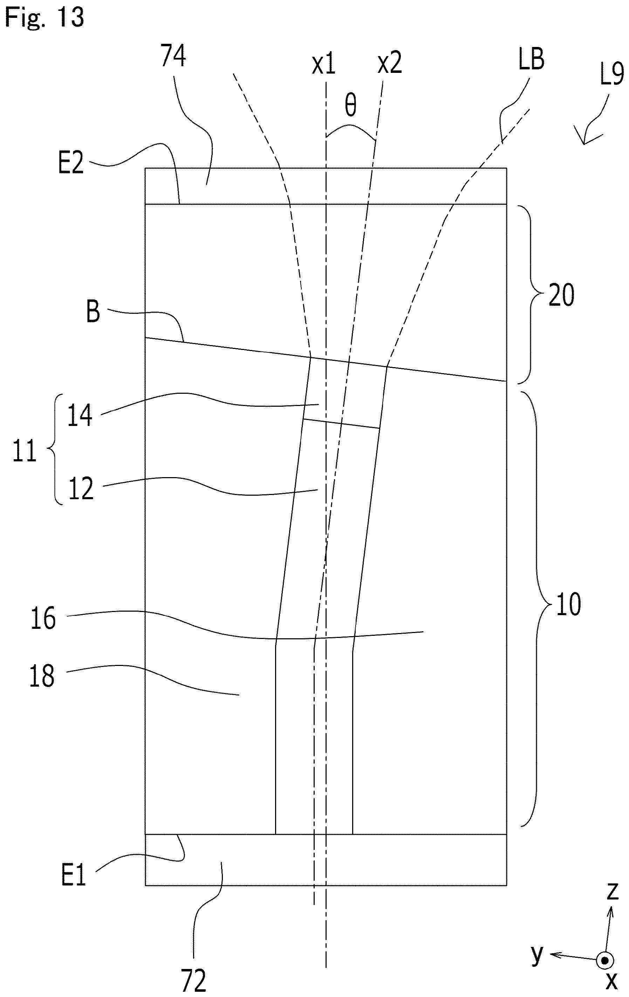

Fig. 13 is a schematic top view illustrating a semiconductor laser element L9 according to a sixth embodiment. The semiconductor laser element L9 according to the sixth embodiment has a structure similar to the semiconductor laser element L4 according to the third modification, but is different from the semiconductor laser element L4 in the following configurations. That is, the optical axis X2 of the resonator 12 of the semiconductor laser element L9 is inclined by an angle $\theta$ with respect to the normal line X1 of the second end surface E2 on the second end surface E2 side, while being parallel to X1 on the first end surface E1 side. In other words, the resonator 12 is bent in its intermediate portion in the top view.

Because the optical axis X2 of the resonator 12 is perpendicular to the first end surface E1 in the vicinity of the first end surface E1, the first end surface E1 can reflect light efficiently.

As described above, the semiconductor laser element described so far can be applied to both semiconductor laser elements in single-mode or multi-mode as transverse mode. The semiconductor laser element can be used for a light source device used in various fields such as a projector, communication, a sensor, a spectrometer, processing, and illumination.

In the semiconductor laser element of the present disclosure, the semiconductor laser elements of the modifications and the embodiments can be appropriately combined.

The present disclosure includes the following configurations.

(Clause 1)

A semiconductor laser element comprising a first region and a second region in each of which a plurality of semiconductor layers are stacked; wherein:

the first region forms a resonator between a first end surface and a mirror region comprising a grating;
in a top view, the first region comprises an optical waveguide comprising:

a core region extending in an optical axis direction of the resonator, and
cladding regions arranged at both sides of the core region in a direction perpendicular to the optical axis direction;

the second region is adjacent to the first region in the optical axis direction;
in a top view, a width of the second region in the direction perpendicular to the optical axis direction is larger than a width of the core region in the direction perpendicular to the optical axis direction; and
the second region comprises a second end surface configured to emit a laser beam.

(Clause 2)

The semiconductor laser element according to clause 1, wherein, in the top view, the optical waveguide is a single-mode waveguide in the direction perpendicular to the optical axis direction.

(Clause 3)

A semiconductor laser element comprising a stack of a plurality of semiconductor layers, the semiconductor laser element comprising:

a channel waveguide as a first region;
a slab waveguide as a second region adjacent to the channel waveguide in an optical axis direction; and
a grating: wherein:

the channel waveguide comprises a resonator formed between a first end surface and the grating; and
the slab waveguide comprises a second end surface on a side opposite to the first end surface with respect to the grating, the second end surface configured to emit a laser beam.

(Clause 4)

The semiconductor laser element according to clause 3, wherein, in the top view, the channel waveguide is a single-mode waveguide in the direction perpendicular to the optical axis direction.

(Clause 5)

The semiconductor laser element according to any one of clauses 1 to 4, wherein, in a cross-sectional view taken along the optical axis direction, more than 50% of an entirety of the grating is located in the first region.

(Clause 6)

The semiconductor laser element according to any one of clauses 1 to 5, wherein:

the grating is provided only in the first region; and
in a cross-sectional view taken along the optical axis direction, a center of the grating is located closer to the second end surface than to the first end surface.

(Clause 7)

The semiconductor laser element according to any one of clauses 1 to 6, wherein:

in the top view, a width of the second end surface perpendicular to the optical axis direction is larger than a width of the laser beam at the second end surface; and
in the top view, a width of the second region perpendicular to the optical axis direction is constant in the optical axis direction.

(Clause 8)

The semiconductor laser element according to any one of clauses 1 to 7, wherein:

the first region has a ridge;
the grating is provided only in the first region; and
in the top view, the grating is provided in an entire region in which the ridge is provided.

(Clause 9)

The semiconductor laser element according to any one of clauses 1 to 8, wherein a length of the resonator is 1000 $\mu$m or more and 10000 $\mu$m or less in the optical axis direction.

(Clause 10)

The semiconductor laser element according to any one of clauses 1 to 9, wherein a length of the second region in the optical axis direction is 0.01 or more and 0.35 or less times a length of the resonator.

(Clause 11)

The semiconductor laser element according to any one of clauses 1 to 10, wherein the second end surface has a lens surface at a position through which the laser beam passes.

(Clause 12)

The semiconductor laser element according to any one of clauses 1 to 11, further comprising:

a high reflection coating arranged on the first end surface; and

an antireflection coating arranged on the second end surface.

(Clause 13)

The semiconductor laser element according to any one of clauses 1 to 12, wherein:

the first region and the second region comprise:

a first conduction-side semiconductor layer,
a second conduction-side semiconductor layer, and
an active layer arranged between the first conduction-side semiconductor layer and the second conduction-side semiconductor layer;

the second conduction-side semiconductor layer of the first region is in contact with a first electrode; and
the grating is arranged in the first conduction-side semiconductor layer or in the second conduction-side semiconductor layer.

(Clause 14)

The semiconductor laser element according to clause 13, wherein the second conduction-side semiconductor layer of the second region is not in contact with the first electrode.

(Clause 15)

The semiconductor laser element according to clauses 13 or 14, wherein the first conduction-side semiconductor layer, the second conduction-side semiconductor layer, and the active layer comprise a nitride semiconductor.

(Clause 16)

A semiconductor laser element comprising a stacked body in which a plurality of semiconductor layers are stacked; wherein:

the stacked body comprises:

a first end surface,
a second end surface that faces the first end surface and emits a laser beam,
a first region arranged on a side of the first end surface, and
a second region arranged on a side of the second end surface;

the first region comprises:

an optical waveguide comprising:

a core region extending along a first direction from the first end surface toward the second end surface, and
a plurality of cladding regions arranged on both sides of the core region in a second direction perpendicular to both the first direction and a stacking direction of the stacked body, and

a grating provided at least in a part of the first region; and

a width of the second region is larger than a width of the core region.

(Clause 17)

The semiconductor laser element according to clause 16, wherein the grating is provided in a portion of the first region adjacent to the second region.

(Clause 18)

The semiconductor laser element according to clauses 16 or 17, wherein, in a top view, the grating is provided in an entire region in which the core region is provided in the first region.

(Clause 19)

The semiconductor laser element according to any one of clauses 16 to 18, wherein:

the grating is provided only in the first region; and
a distance between the grating and the second end surface is smaller than a distance between the grating and the first end surface.

(Clause 20)

The semiconductor laser element according to any one of clauses 16 to 19, wherein:

the second region has a constant width: and
a width of the second end surface is larger than a width of the laser beam at the second end surface.

(Clause 21)

The semiconductor laser element according to claim 18, wherein:

the first region has a ridge; and
in a top view, the grating is provided in an entire region in which the ridge is provided.

## Claims

1. A semiconductor laser element comprising:

    (i) a first region and a second region in each of which a plurality of semiconductor layers are stacked; wherein:

    the first region forms a resonator between a first end surface and a mirror region comprising a grating;
    in a top view, the first region comprises an optical waveguide comprising:

    a core region extending in an optical axis direction of the resonator, and cladding regions arranged at both sides of the core region in a direction perpendicular to the optical axis direction;

    the second region is adjacent to the first region in the optical axis direction;
    in a top view, a width of the second region in the direction perpendicular to the optical axis direction is larger than a width of the core region in the direction perpendicular to the optical axis direction; and
    the second region comprises a second end surface configured to emit a laser beam, or

    (ii) a channel waveguide as a first region;

    a slab waveguide as a second region adjacent to the channel waveguide in an optical axis direction; and
    a grating: wherein:

    the channel waveguide comprises a resonator formed between a first end surface and the grating; and
    the slab waveguide comprises a second end surface on a side opposite to the first end surface with respect to the grating, the second end surface configured to emit a laser beam.

2. The semiconductor laser element according to claim 1, wherein, in the (i), in the top view, the optical waveguide is a single-mode waveguide in the direction perpendicular to the optical axis direction.

3. The semiconductor laser element according to claim 1, wherein, in the (ii), in the top view, the channel waveguide is a single-mode waveguide in the direction perpendicular to the optical axis direction.

4. The semiconductor laser element according to any one of claims 1 to 3, wherein, in a cross-sectional view taken along the optical axis direction, more than 50% of an entirety of the grating is located in the first region.

5. The semiconductor laser element according to any one of claims 1 to 4, wherein:

    the grating is provided only in the first region; and
    in a cross-sectional view taken along the optical axis direction, a center of the grating is located closer to the second end surface than to the first end surface.

6. The semiconductor laser element according to any one of claims 1 to 5, wherein:

    in the top view, a width of the second end surface perpendicular to the optical axis direction is larger than a width of the laser beam at the second end surface; and
    in the top view, a width of the second region perpendicular to the optical axis direction is constant in the optical axis direction.

7. The semiconductor laser element according to any one of claims 1 to 6, wherein:

    the first region has a ridge;
    the grating is provided only in the first region; and
    in the top view, the grating is provided in an entire region in which the ridge is provided.

8. The semiconductor laser element according to any one of claims 1 to 7, wherein a length of the resonator is 1000 $\mu$m or more and 10000 $\mu$m or less in the optical axis direction.

9. The semiconductor laser element according to any one of claims 1 to 8, wherein a length of the second region in the optical axis direction is 0.01 or more and 0.35 or less times a length of the resonator.

10. The semiconductor laser element according to any one of claims 1 to 9, wherein the second end surface has a lens surface at a position through which the laser beam passes.

11. The semiconductor laser element according to any one of claims 1 to 10, further comprising:

    a high reflection coating arranged on the first end surface; and
    an antireflection coating arranged on the second end surface.

12. The semiconductor laser element according to any one of claims 1 to 11, wherein:

**EP 4 746 216 A2**

the first region and the second region comprise:

> a first conduction-side semiconductor layer,
> a second conduction-side semiconductor layer, and
> an active layer arranged between the first conduction-side semiconductor layer and the second conduction-side semiconductor layer;

the second conduction-side semiconductor layer of the first region is in contact with a first electrode; and
the grating is arranged in the first conduction-side semiconductor layer or in the second conduction-side semiconductor layer.

13. The semiconductor laser element according to claim 12, wherein the second conduction-side semiconductor layer of the second region is not in contact with the first electrode.

14. The semiconductor laser element according to claims 12 or 13, wherein the first conduction-side semiconductor layer, the second conduction-side semiconductor layer, and the active layer comprise a nitride semiconductor.

Fig. 1

Fig. 2

Fig. 3

Fig. 4

Fig. 5

Fig. 6

Fig. 7

Fig. 8

EP 4 746 216 A2

Fig. 9

Fig. 10

EP 4 746 216 A2

Fig. 11

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024188182 A
- JP 2025177239 A
- JP 2004520710 A